# FASCICULE DE BREVET EUROPEEN

(11) **EP 0 447 277 B1**
(45) Date de publication et mention de la délivrance du brevet: **16.06.1993**
(21) Numéro de dépôt: 91400335.5
(22) Date de dépôt: 12.02.1991
(51) Int. Cl.: G11C 16/06

(54) **Mémoire ultra-rapide comportant un limiteur de la tension de drain des cellules**
Ultrahochgeschwindigkeitsspeicher mit Drainspannungsbegrenzer für Zellen
Ultra high speed memory having a drain voltage limiter for cells

(30) Priorité: 05.03.1990 FR 9002737
(43) Date de publication de la demande: 18.09.1991
(73) Titulaire: SGS-THOMSON MICROELECTRONICS S.A., 94250 Gentilly (FR)
(72) Inventeur: Devin, Jean, F-75116 Paris (FR); Yero, Emilio, F-75116 Paris (FR); Costabello, Claude, F-75116 Paris (FR)
(74) Mandataire: Schmit, Christian Norbert Marie

(56) Documents cités:
- EP-A- 0 329 141
- US-A- 3 765 002
- US-A- 4 843 594

## Description

L'invention concerne un limiteur de tension de drain pour mémoire MOS programmable électriquement, effaçable, de faible capacité, et qui soit ultra-rapide en lecture.

Les cellules mémoire électriquement programmables sont constituées d'un transistor à grille flottante dont la grille de commande est reliée à une ligne de mot, le drain à une ligne de bit et la source à un potentiel de référence qui est en général la masse électrique du circuit.

L'organisation des cellules est matricielle : les transistors (ou points mémoire) sont disposés en lignes et colonnes. Les transistors d'une même ligne ont leurs grilles de commande reliées à une même ligne de mot; les transistors d'une même colonne ont leurs drains reliés à une même ligne de bit. L'adressage d'un point mémoire se fait par l'adressage d'une ligne de bit et d'une ligne de mot.

La programmation et l'effacement d'un point mémoire consiste à injecter ou à faire partir des charges électriques dans la grille flottante, par application par exemple de potentiels élevés, effacement par rayons ultra-violets... Ce sont des méthodes bien connues.

La quantité de charges stockées sur la grille flottante détermine la tension de seuil Vs du transistor : en valeur absolue, c'est la tension minimale à appliquer entre la grille et la source pour que la cellule se mette à conduire. Pour un transistor canal N, on pourra, par exemple, avoir une tension de seuil de 2 volts pour un état effacé, de 8 volts pour un état programmé. Ainsi, si on applique une tension de lecture entre la source et le drain de l'ordre de 5 volts, la cellule conduit un courant d'une centaine de microampères si elle est effacée, elle ne conduit pas si elle est programmée.

Le courant que conduit la cellule est très faible. Aussi, la lecture de l'état de la cellule nécessite une conversion courant-tension. Une réalisation simple bien connue est la précharge de la ligne de bit par un générateur de courant, qui porte le drain à un potentiel proche de Vcc. Le générateur de courant sera classiquement réalisé par un transis(or résistif à tension de seuil nulle, dont la grille et la source sont court-circuitées. En appliquant une tension de lecture entre la source et la grille de la cellule, si la cellule conduit elle va faire tendre son drain vers 0 volts. Si elle ne conduit pas, le drain reste à la même tension de précharge, proche de Vcc. Un amplificateur de lecture centré sur un seuil de détection compris entre 0 et 5 volts peut alors détecter un état effacé ou un état programmé.

A cause de l'organisation matricielle des mémoires, les lignes de bit, qui comportent beaucoup de cellules, et qui sont toutes reliées à l'amplificateur de lecture, sont fortement capacitives : en parallèle sur le drain et la source (à la masse), on peut représenter la capacité C équivalente. La cellule est elle très résistive : le courant qui circule est très faible. Il s'ensuit que l'établissement de la donnée d'un point mémoire sur la ligne de bit est très long. Surtout si on doit lire un état opposé à celui prépositionné sur la ligne de bit, soit donc un état effacé alors que la ligne de bit est prépositionnée à un état programmé par le circuit de précharge (générateur de courant).

De plus, le drain de la cellule subit des variations importantes de tension : passage de Vcc, état prépositionné programmé, à 0 volts pour la lecture d'un état effacé. Des lectures répétées tendent alors à modifier la quantité de charges stockées sur la grille flottante ; la cellule a tendance à être programmée. Sa durée de vie devient plus faible; c'est un phénomène de stress de la cellule. Il est particulièrement sensible quand les longueurs de grille sont faibles (submicroniques). On connaît du brevet US 4,843,594 un générateur de faible tension de polarisation pour réduire ce stress.

On connaît aussi, comme montré dans la demande EP-A-0329 141, un circuit introduit entre la ligne de bit et le drain de la cellule dont la fonction est d'absorber la différence de tension provoquée par la lecture d'un état effacé, la ligne de bit étant prépositionnée pour un état programmé : le potentiel du drain de la cellule mémoire varie beaucoup moins. Ce circuit de limitation de la variation du drain en tension est, de manière connue, composé d'un transistor que l'on va qualifier de transistor de compensation, monté en série entre la ligne de bit et le drain de la cellule mémoire. La source de ce transistor est donc connectée au drain de la cellule. Elle est également l'entrée d'un inverseur suiveur dont la sortie est connectée à la grille du transistor. Le drain du transistor est connecté à l'entrée du circuit de lecture et à la sortie du circuit de précharge.

Ce transistor de compensation est plus résistif que la cellule mémoire, mais moins que le transistor ou le circuit de précharge.

Ainsi, si la cellule est dans un état effacé et si on applique sur sa grille la tension de lecture, le courant de la cellule devient important et tend à faire diminuer sa tension de drain Vd. Du fait de l'inverseur suiveur, la tension de grille du transistor de compensation devient elle plus grande : il est de plus en plus conducteur, équivalent à un court-circuit.

Par contre, si la cellule est dans un état programmé, elle devient très résistive. Comme le transistor de compensation est plus résistif, et du fait de l'inverseur, le transistor de compensation devient très résistif, plus que la cellule et prend la différence de tension à ses bornes : Vd bouge donc très peu.

Cependant, si on a limité ainsi l'effet de stress, le problème de temps d'accès en lecture, long à cause de la capacité, n'est pas pour autant résolu, même si, la variation de tension étant moindre, le temps d'accès est aussi plus court (CdV = idt).

Un objet de l'invention est d'utiliser un tel montage avec transistor de compensation, pour un nombre petit de cellules, pour avoir une mémoire très rapide en lecture. La capacité induite est plus faible , car il y a moins de cellules. Mais c'est alors le temps de transmission de l'inverseur qui va gêner une commutation rapide : la compensation ne suit pas et en pratique, il y a des pics de tension sur le drain,car la capacité induite est trop faible. On retrouve le problème du stress de la cellule.

L'invention a donc pour objet une mémoire programmable électriquement et effaçable, organisée matriciellement en lignes et colonnes, chaque colonne étant sélectionnée par une ligne de bit et comportant plusieurs cellules mémoire, chaque ligne de bit comportant un circuit de précharge, un circuit de compensation étant placé en série entre la ligne de bit et chacune des cellules de la colonne correspondante, le circuit de compensation comportant un transistor de compensation dont le drain est connecté à la sortie du circuit de précharge et dont la source est connecté au drain des cellules mémoires de la colonne et un inverseur dont la sortie commande la grille du transistor de compensation et dont l'entrée est connectée à la source du transistor de compensation, caractérisée en ce que la tension de grille du transistor de compensation est par ailleurs limitée par un limiteur de tension.

Les caractéristiques et avantages de l'invention sont présentés dans la description qui suit, faite à titre indicatif et non limitatif de l'invention et au regard des dessins annexés, dans lesquels :
- la figure 1 est un schéma électrique d'un circuit de lecture d'une cellule selon l'invention.
- la figure 2 est un diagramme d'excursion de la tension de drain.

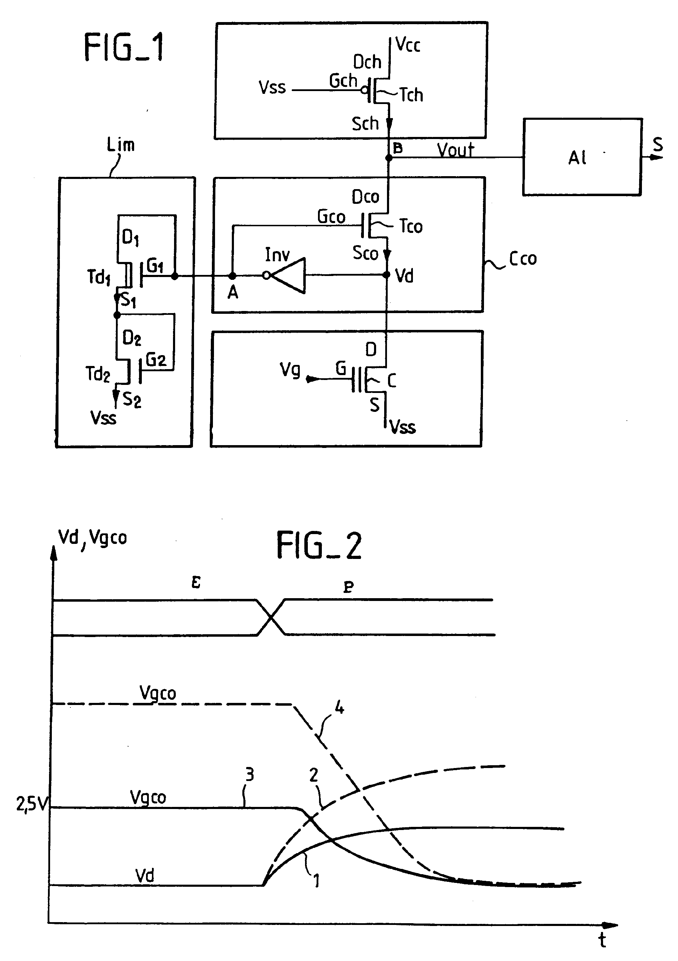

La figure 1 montre un exemple de réalisation d'un circuit de lecture d'une cellule mémoire, permettant une commutation rapide des données sur la ligne de bit, sans stresser les cellules mémoires.

Une cellule mémoire C a une grille G, un drain D et une source S. Le potentiel du drain est Vd, de la grille, Vg et de la source, Vss, masse électrique du circuit.

Un transistor de compensation Tco a une grille Gco, un drain Dco et une source Sco. Il est plus résistif que la cellule mémoire C.

Un transistor de précharge Tch à une grille Gch, un drain Dch et une source Sch. Le potentiel du drain Dch est Vcc, alimentation du circuit. Quand la ligne de bit est sélectionnée en lecture, le potentiel de la grille Gch est mise à la masse électrique du circuit, Vss. Le transistor de précharge Tch est plus résistif que le transistor de compensation Tco.

Le transistor de précharge, le transistor de compensation et la cellule mémoire sont montés en série entre Vcc et la masse : la source Sch est connectée au drain Dco; la source Sco est connectée au drain D; le drain Dch et la source S sont par ailleurs connectés comme on l'a vu, à Vcc et Vss respectivement.

Le point de connexion B entre la source Sch du transistor de précharge et le drain Dco du transistor de compensation est la sortie Vout lue par un amplificateur de lecture Al.

La source Sco du transistor de compensation Tco est par ailleurs connectée à l'entrée d'un inverseur suiveur Inv, dont la sortie A est connectée à la grille Gco de ce même transistor. Le transistor Tco et l'inverseur suiveur Inv forment un circuit de compensation Cco.

La sortie A de l'inverseur Inv du circuit de compensation Cco est connectée à un limiteur de tension Lim. Ce limiteur empêche la tension au point A, et donc la tension de la grille Gco, de monter au-dessus de la tension limite qu'il impose.

Ce limiteur est dans l'exemple composé de deux transistors montés en diode : Td1 a une grille G1, un drain D1 et une source S1. Td2 a une grille G2, un drain D2 et une source S2. Les grilles respectives G1 et G2 de chaque transistor sont reliées aux drains respectifs D1 et D2. Les deux transistors Td1 et Td2 sont montés en série entre le point A et la masse électrique du circuit Vss : le drain D1 (et donc la grille G1) est relié au point A, sortie de l'inverseur suiveur Inv; la source S1 est reliée au drain D2; la source S2 est reliée à la masse électrique du circuit Vss.

Comme les deux transistors sont montés en diode et polarisés en direct, la tension maximale entre le drain et la source de chacun d'eux est égale à leur tension de seuil respective. Au total, la tension maximale entre A et Vss est donc égale à la somme des tensions de seuil V1 et V2 de chacun de ces transistors Td1 et Td2, par exemple 2,5 volts. Suivant la valeur de la tension limite voulue, on pourra mettre plus ou moins de transistors ainsi montés en diode.

Ainsi supposons que la cellule C soit dans un état effacé. La ligne de bit préchargée est positionnée pour un état programmé : Vout vaut sensiblement Vcc. Si on impose une tension de lecture, par exemple de 5 volts, sur la grille G de la cellule (Vg = 5v), la cellule se met à conduire : elle fait tendre son potentiel de drain Vd vers la masse Vss.

En sortie de l'inverseur, la tension de la grille Gco tend elle à augmenter, avec un certain retard, dû au temps de traversée de l'inverseur. Le transistor de compensation Tco se met à conduire de plus en plus, son impédance diminue : il tend à être un court-circuit et Vout tend vers la masse Vss.

Cependant, la tension de la grille Gco ne continue pas à augmenter : dès que la tension atteint la tension imposée par le limiteur, elle reste alors à cette valeur. La tension Vd est elle aussi bloquée à la valeur inverse correspondante, jusqu'à la fin de la lecture.

Quand la cellule est dans un état programmé, la cellule lue va être très résistive. Elle laisse passer très peu de courant et son potentiel de drain Vd tend à augmenter. La tension de la grille Gco devient inversement très faible. Comme le transistor Tco est plus résistif que la cellule, il empêche la tension de drain Vd d'augmenter et c'est lui qui absorbe la différence de tension la plus importante. Vd bouge donc très peu.

Grâce à ce montage qui limite la valeur de la tension de drain et sa variation, les excursions dues à la commutation rapide état programmé/état effacé sont donc réduites. C'est ce que montre la figure 2, sur laquelle les courbes de variations 1 et 3 de tension de drain D de la cellule et de la grille Gco du transistor de compensation sont représentées en trait plein. On a aussi représenté en pointillé celles, 2 et 4 obtenues sans limiteur Lim.

Si on part d'un état effacé (E), on a la tension Vgco de la grille Gco qui est grande, celle Vd du drain D qui est petite. Quand on commute sur un état programmé (P), Vd devient grande et Vgco petite. Plus Vgco était petite pour l'état effacé, moins Vd a le temps de monter, le transistor de compensation étant plus résistif que la cellule. L'excursion de Vd est donc limitée en utilisant un limiteur de la tension Vgco : on dispose alors d'une mémoire de faible capacité, c'est à dire avec peu de cellules mémoire, à accés ultra-rapide sans céder à la fiabilité, puisque les cellules ne sont pas stressées.

## Revendications

1. Mémoire programmable électriquement et effaçable, organisée matriciellement en lignes et colonnes, chaque colonne étant sélectionnée par une ligne de bit et comportant plusieurs cellules mémoire, chaque ligne de bit comportant un circuit de précharge, un circuit de compensation (Cco) étant placé en série entre la ligne de bit et chacune des cellules (C) de la colonne correspondante, le circuit de compensation comportant un transistor de compensation (Tco) dont le drain (Dco) est connecté à la sortie du circuit de précharge et dont la source (Sco) est connecté au drain (D) des cellules mémoires de la colonne et un inverseur (Inv) dont la sortie commande la grille (Gco) du transistor de compensation et dont l'entrée est connectée à la source (Sco) du transistor de compensation, caractérisée en ce que la tension de grille du transistor de compensation est par ailleurs limitée par un limiteur de tension (Lim).

2. Mémoire selon la revendication 1, caractérisée en ce que le limiteur (Lim) est réalisé par au moins un transistor (T1) monté en diode, imposant une tension limite égale à la tension de seuil du transistor (T1) monté en diode.

## Patentansprüche

1. Elektrisch programmierbarer und löschbarer Speicher, der matrixförmig in Zeilen und Spalten aufgebaut ist, wobei jede Spalte durch eine Bitleitung gewählt wird und mehrere Speicherzellen umfaßt, wobei jede Bitleitung eine Vorladungsschaltung aufweist, wobei zwischen der Bitleitung und jeder der Zellen (C) der entsprechenden Spalte eine Kompensationsschaltung (Cco) in Reihe geschaltet ist, wobei die Kompensationsschaltung versehen ist mit einem Kompensationstransistor (Tco), dessen Drain (Dco) mit dem Ausgang der Vorladungsschaltung verbunden ist und dessen Source (Sco) mit dem Drain (D) der Speicherzellen der Spalte verbunden ist, und einem Invertierer (Inv), dessen Ausgang das Gate (Gco) des Kompensationstransistors steuert und dessen Eingang mit der Source (Sco) des Kompensationstransistors verbunden ist, dadurch gekennzeichnet, daß die Gatespannung des Kompensationstransistors außerdem durch einen Spannungsbegrenzer (Lim) begrenzt wird.

2. Speicher gemäß Anspruch 1, dadurch gekennzeichnet, daß der Begrenzer (Lim) durch wenigstens einen Transistor (T1) verwirklicht ist, der als Diode geschaltet ist und eine Grenzspannung anlegt, die gleich der Schwellenspannung des als Diode geschalteten Transistors (T1) ist.

## Claims

1. Electrically programmable and erasable memory, organized matricially in lines and columns, each column being selected by a bit line and having several memory cells, each bit line having a pre-charge circuit, a compensation circuit (Cco) being placed in series between the bit line and each of the cells (C) of the corresponding column, the compensation circuit having a compensation transistor (Tco) whose drain (Dco) is connected to the output of the pre-charge circuit and whose source (Sco) is connected to the drain (D) of the memory cells of the column, and an inverter (Inv) whose output controls the gate (Gco) of the compensation transistor and whose input is connected to the source (Sco) of the compensation transistor, characterized in that the gate voltage of the compensation transistor is furthermore limited by a voltage limiter (Lim).

2. Memory according to Claim 1, characterized in that the voltage limiter (Lim) is made up of at least one transistor (T1) connected as a diode imposing a limit voltage equal to the threshold voltage of the transistor (T1) connected as a diode.
